# EUROPEAN PATENT APPLICATION

(11) **EP 1 873 845 A1**
(43) Date of publication of application: **02.01.2008**
(21) Application number: 06115143.7
(22) Date of filing: 08.06.2006
(51) Int. Cl.: H01L 51/52

(54) **System for displaying images**

(71) Applicant: Toppoly Optoelectronics Corp., Miao-Li County (TW); National Taiwan University, Taipei 106 (TW)
(72) Inventor: Tsai, Yaw-Ming, 414, Wurih Township, Taichung County (TW); Nishikawa, Ryuji, 350, Jhunan Township, Miaoli County 350 (TW); Chen, Liang-Jyi, 106, Da-an District, Taipei City (TW); Hsu, Hsiang-Lun, 360, Miaoli City, Miaoli County (TW); Lu, Po-Yen 3F., No. 11, Sub-Alley 3, Alley 88, 325, Longtan Township, Taoyuan County (TW); Wu, Chung-Chih, 106, Da-an District, Taipei City (TW); Lu, Yin-Jui, 701, East District, Tainan City (TW); Chen, Chieh-Wei, 420, Fongyuan City, Taichung County (TW)
(74) Representative: Patentanwälte Kewitz & Kollegen

(57) **Abstract**

Systems for displaying images. A representative system incorporates an electroluminescent diode that includes a composite electrode structure. Particularly, the composite electrode structure comprises a layer containing alkali or alkaline earth compounds, and a metal oxide layer or semiconductor layer. Wherein, the alkali or alkaline earth compound has carbonyl group or fluorine.

## Description

### BACKGROUND OF THE INVENTION

### Field of the Invention

The invention relates to a system for displaying images and, more particularly, to a system for displaying images comprising a tandem organic electroluminescent diode.

### Description of the Related Art

Recently, with the development and wide application of electronic products, such as mobile phones, PDA, and notebook computers, there has been increasing demand for flat display elements which consume less power and occupy less space. Organic electroluminescent elements are popular for use in flat panel display as they are self-emitting and highly luminous, provide wider viewing angle, faster response speed, and a simple fabrication process.

An organic light-emitting diodes (OLEDs) is a light-emitting diode that uses an organic electroluminescent layer as the increasingly gradually employed in flat panel displays. One trend in organic electroluminescent display technology is for higher luminescent efficiency and longer lifetime.

To further improve the performance of the OLEDs and achieve a full-color image, a new kind of OLED structure called tandem OLED (or stacked OLED, or cascaded OLED), which is fabricated by stacking several individual OLEDs vertically and driven by a single power source, has also been proposed.

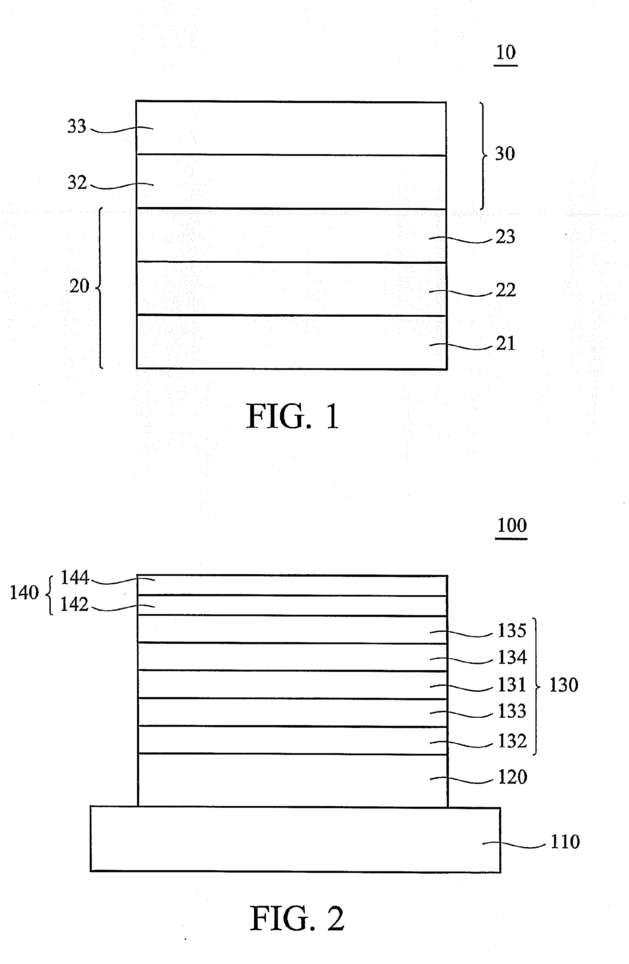

Please referring to Fig. 1, a conventional tandem OLED 10 comprises a first organic light-emitting diode 20 and a second organic light-emitting diode 30 vertically stacked on the first organic light-emitting diode 20. Particularly, the first organic light-emitting diode 20 comprises first electrode 21, a first electroluminescent layer 22, a connecting electrode 23, serving as a top electrode of first organic light-emitting diode 20, and second organic light-emitting diode 30 comprises the connecting electrode 23, serving as a bottom electrode of second organic light-emitting diode 20, a second electroluminescent layer 32, a second electrode 33. It should be noted that the connecting electrode 23 is formed between the first electroluminescent layer 22 and the second electroluminescent layer 32.

The major challenge in tandem OLEDs in general is to prepare the effective connecting structure between emitting units so that the current can smoothly flow through without facing substantial barriers. Several connecting structures have been developed and are disclosed in the following.

Forrest, S. R (Science 1997, 276, 2009; J. App. Phys. 1999, 86, 4067; J. App. Phys. 1999, 864076) disclosed an OLED with tandem OLED's structure using an ITO film as a connecting electrode. The method for forming the tandem OLED comprises forming the ITO film on a first electroluminescent layer by sputtering, and forming a second electroluminescent layer on the ITO film. In sputtering of a transparent conductive layer, the top surface of the underlying first electroluminescent layer damages, deteriorates, decomposes and roughens by ion bombardment during the sputter deposition. Thus, the energy barriers of the interfaces between the transparent cathode and the electroluminescent layers increase, and the carrier movement between layers is less likely to occur, resulting in a higher operating voltage and shorter lifetime.

Howard, W. E. and Jones, G.W (US patent 6337492 B1) demonstrated a three-emitting-unit tandem OLED using Mg:Ag/IZO film as connecting electrode structure, enhancing the carrier transportation. Specifically, the Mg:Ag layer and IZO layer are subsequently formed on the underlying electroluminescent layer. Since the Mg:Ag layer has a thin thickness and the IZO layer is formed by sputtering, the underlying electroluminescent layer damages, deteriorates, decomposes and roughens by ion bombardment.

Kido, J (SID 03 Digest 2003, 34, 979) described a tandem OLED using Cs:Bphen/V2O5 as connecting electrode structure, achieved a luminous efficiency of two times larger than that of single emitting-unit OLED. Due to the high cost of Cs and Bphen, the production costs of the tandem OLED comprising Cs:Bphen/V2O5 are increased. Moreover, Cs is apt to be oxidized during evaporation.

Tang, C. W. (Appl. Phys. Lett. 2004, 84, 167) described a tandem OLED using Alq:Li (or TPBI:Li)/NPB:FeCl3 as connecting electrode structure, achieved a luminous efficiency of two times larger than that of single emitting-unit OLED. The method for fabricating the tandem OLED comprises co-evaporating Alq (or TBPI) and Li from two sources and then co-evaporating NPB and FeCl3 to form a NPB:FeCl3 layer on the Alq:Li (or TPBI:Li) layer. However, it is difficult to accurately control the doping concentration of Li. Moreover, Li is apt to be oxidized during evaporation.

Chen, C. H. (Jpn J. Appl. Phys. 2004, 43, 6418) described a tandem OLED using Alq:Mg/W03 as connecting electrode structure, achieved a luminous efficiency of four times larger than that of single emitting-unit OLED. The tandem OLED, however, shows a color shift.

Tsutsui, T (Curr. Appl. Phys. 2005, 5, 341) described a tandem OLED using Alq:Mg/V2O5 as connecting electrode structure, achieved double the luminous efficiency.

Kwok, H. S. (Appl. Phys. Lett. 2005, 87, 093504) described a tandem OLED using LiF/Ca/Ag(or Au) as connecting electrode structure, achieved the 1.9 times uminous efficiency. Since the Ca layer is apt to be oxidized, the reliability of the tandem OLED is thus reduced.

Therefore, it is necessary to develop a tandem OLED with novel connecting electrode structure and low operating voltage in order to accommodate in to practical use.

### BRIEF SUMMARY OF THE INVENTION

Systems for displaying images are provided. An exemplary embodiment of such as system comprises a normal organic electroluminescent diode (single electroluminescent unit), comprising a composite electrode structure. Particularly, the composite electrode structure comprises a layer containing alkali or alkaline earth compounds, and a metal oxide layer or semiconductor layer. Wherein, the alkali or alkaline earth compound has carbonyl group or fluorine. In some embodiments of the invention, the composite electrode structure can serve as an anode electrode or a cathode electrode.

In another exemplary embodiment, a system for displaying images is provided. The system comprises a tandem organic electroluminescent diode, comprising a first electrode, a second electrode, a plurality of electroluminescent units, and at least one connecting electrode structure. The plurality of electroluminescent units is formed between the first and second electrodes, and two adjacent electroluminescent units are separated by the connecting electrode structure. Particularly, the connecting electrode structure comprises a layer containing alkali or alkaline earth compounds, and a metal oxide layer or semiconductor layer. The alkali or alkaline earth compound has carbonyl group or fluorine.

Systems for displaying images according to the invention have high luminescent efficiency and prevent the color shift of tandem organic electroluminescent devices, thus meeting the demands of the flat panel display market.

A detailed description is given in the following embodiments with reference to the accompanying drawings.

### BRIEF DESCRIPTION OF THE DRAWINGS

The invention can be more fully understood by reading the subsequent detailed description and examples with references made to the accompanying drawings, wherein:

Fig. 1 shows a cross section of a conventional tandem organic electroluminescent device.

Fig. 2 shows a cross section of an embodiment of a normal electroluminescent diode having the composite electrode structure.

Fig. 3 shows a cross section of an embodiment of a tandem organic electroluminescent diode.

Fig. 4 shows a cross section of another embodiment of a tandem organic electroluminescent diode.

Fig. 5 shows a graph plotting operating voltage against current density of the electroluminescent devices as disclosed in Comparative Example 1 and Examples 1~4.

Fig. 6 shows a graph plotting current density against brightness of the electroluminescent devices as disclosed in Comparative Example 1 and Examples 1~4.

Fig. 7 shows a graph plotting current density against efficiency of the electroluminescent devices as disclosed in Example 1 and Comparative Example 1.

Fig. 8 shows a graph plotting operating voltage against current density of the electroluminescent devices as disclosed in Comparative Example 2 and Examples 5~7.

Fig. 9 shows a graph plotting current density against brightness of the electroluminescent devices as disclosed in Comparative Example 2 and Examples 5~7.

Fig. 10 shows a graph plotting current density against efficiency of the electroluminescent devices as disclosed in Comparative Example 2 and Examples 5~7.

Fig. 11 shows a graph plotting density against emission wavelength as disclosed in Comparative Example 2 and Examples 5~7

Fig. 12 schematically shows another embodiment of a system for displaying images.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

Referring to Fig. 2, is a cross section of a normal organic electroluminescent diode 100 (single electroluminescent unit) according to an embodiment of the invention. The normal organic electroluminescent diode 100 comprises a substrate 110 of an insulating material such as glass, plastic, or ceramic. Further, the substrate 110 can be a semiconductor substrate, transparent or optionally opaque, specifically a transparent substrate when the organic electroluminescent diode 100 is a bottom-emission or dual emission organic electroluminescent device, and an opaque substrate when the organic electroluminescent diode 100 is a top-emission organic electroluminescent device.

A first electrode such as an anode electrode 120 is formed on the substrate 110, and can be a transparent electrode, metal electrode, or combinations thereof, comprising indium tin oxide (ITO), indium zinc oxide (IZO), aluminum zinc oxide (AZO), zinc oxide (ZnO), Li, Mg, Ca, Al, Ag, In, Au, Ni, Pt, or alloys thereof, formed by a method such as sputtering, electron beam evaporation, thermal evaporation, or chemical vapor deposition.

An electroluminescent layer 130 is formed on the anode electrode 120, wherein the electroluminescent layer 130 at least comprises a light emitting layer 131, and can further comprises a hole injection layer 132, a hole transport layer 133, an electron transport layer 134, and an electron injection layer 135, as shown in Fig. 2. The electroluminescent layer 130 is organic semiconductor material such as small molecule material, polymer, or organometallic complex, and can be formed by thermal vacuum evaporation, spin coating, dip coating, roll-coating, injection-fill, embossing, stamping, physical vapor deposition, or chemical vapor deposition. The emitting layer 131 comprises a light-emitting material and an electroluminescent dopant doped into the light-emitting material and can perform energy transfer or carrier trapping under electron-hole recombination in the emitting layer. The light-emitting material can be fluorescent or phosphorescent.

Still referring to Fig. 2, a composite electrode structure 140 is formed on the electroluminescent layer 130. Herein, the composite electrode structure 140 serves as the cathode electrode of the normal organic electroluminescent diode 100 (single electroluminescent unit).

The composite electrode structure 140 can comprise a layer containing alkali or alkaline earth compounds 142 and a metal oxide layer or semiconductor layer 144. Wherein the alkali or alkaline earth compound can have carbonyl group or fluorine. The alkali or alkaline earth compound can comprise a fluoride containing Li, Na, K, Rb, Cs, Be, Mg, Ca, Sr, or Ba, such as NaF, KF, RbF, CsF, BeF₂, MgF₂, CaF₂, SrF₂, or BaF₂. Furthermore, the alkali or alkaline earth compound can comprise a carbonyl compound containing Li, Na, K, Rb, Cs, Be, Mg, Ca, Sr, or Ba, such as Li₂CO₃, LiCO₃, Na₂CO₃, NaCO₃, K₂CO₃, KCO₃, Rb₂CO₃, RbCO₃, Cs₂CO₃, CsCO3, BeCO, BeCO₃, MgCO, MgCO₃, CaO, Ca₂CO₃, CaCO₃, SrCO, SrCO₃, BaCO, or BaCO₃. It should be noted that the layer containing alkali or alkaline earth compound can be further doped with an electron transport material, such as Alq₃, BeBq₂, TPBI, PBD, or TAZ.

The metal oxide layer can comprise oxide of transition metal, wherein the transition metal comprises atoms of Group IB, Group IIB, Group IVB, Group VB, Group VIIIB, Cr , or W. In some embodiments, the metal oxide layer can comprise WO, W₂O₃, WO₂, WO₃, W₂O₅, VO, V₂O₃, VO₂, or V₂O₅.

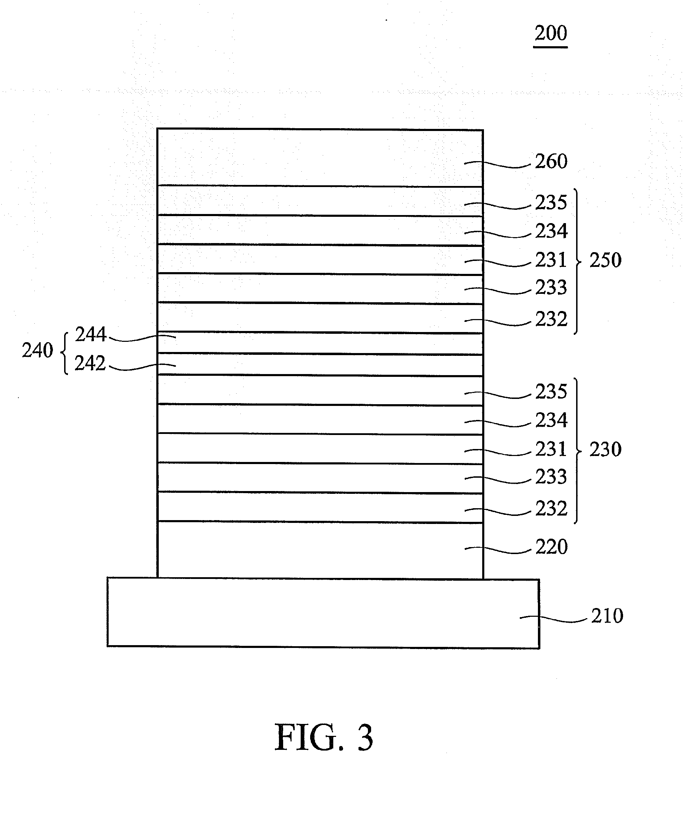

The semiconductor layer can comprise Si, Ge, GaAs, SiC, or SiGe. In an embodiment of the invention, the semiconductor layer is a non-doped semiconductor layer. Furthermore, the semiconductor layer comprises a n-type (B) doping ions (P, As, Sb) or p-type ions doping semiconductor layer. Fig. 3 shows a cross section of a tandem organic electroluminescent diode 200, such as a tandem organic electroluminescent diode having two electroluminescent units. In some embodiments of the invention, the tandem organic electroluminescent diode can have more than two electroluminescent units. The tandem organic electroluminescent diode 200 comprises a substrate 210 of an insulating material such as glass, plastic, or ceramic. Further, the substrate 110 can be a semiconductor substrate, transparent or optionally opaque, specifically a transparent substrate when the organic electroluminescent diode 200 is a bottom-emission or dual emission organic electroluminescent device, and an opaque substrate when the organic electroluminescent diode 200 is a top-emission organic electroluminescent device.

A first electrode such as an anode electrode 220 is formed on the substrate 210, and can be a transparent electrode, metal electrode, or combinations thereof, comprising indium tin oxide (ITO), indium zinc oxide (IZO), aluminum zinc oxide (AZO), zinc oxide (ZnO), Li, Mg, Ca, Al, Ag, In, Au, Ni, Pt, or alloys thereof, formed by a method such as sputtering, electron beam evaporation, thermal evaporation, or chemical vapor deposition. A first electroluminescent unit 230 is formed on the anode electrode 220, wherein the first electroluminescent unit 230 at least comprises a light emitting layer 231, and can further comprise a hole injection layer 232, a hole transport layer 233, an electron transport layer 234, and an electron injection layer 235, as shown in Fig. 3. The electroluminescent layer 230 is organic semiconductor material such as small molecule material, polymer, or organometallic complex, and can be formed by thermal vacuum evaporation, spin coating, dip coating, roll-coating, injection-fill, embossing, stamping, physical vapor deposition, or chemical vapor deposition. The emitting layer 231 comprises a light-emitting material and an electroluminescent dopant doped into the light-emitting material and can perform energy transfer or carrier trapping under electron-hole recombination in the emitting layer. The light-emitting material can be fluorescent or phosphorescent.

Still referring to Fig. 3, a connecting electrode structure 240 is formed on the first electroluminescent unit 230. The connecting electrode structure 240 can comprise a layer containing alkali or alkaline earth compounds 242 and a metal oxide layer or semiconductor layer 244. Wherein, the alkali or alkaline earth compound can have carbonyl group or fluorine. The alkali or alkaline earth compound can comprise a fluoride containing Li, Na, K, Rb, Cs, Be, Mg, Ca, Sr, or Ba, such as NaF, KF, RbF, CsF, BeF₂, MgF₂, CaF₂, SrF₂, or BaF₂. Furthermore, the alkali or alkaline earth compound can comprise a carbonyl compound containing Li, Na, K, Rb, Cs, Be, Mg, Ca, Sr, or Ba, such as Li₂CO₃, LiCO₃, Na₂CO₃, NaCO₃, K₂CO₃, KCO₃, Rb₂CO₃, RbCO₃, Cs₂CO₃, CsCO3, BeCO, BeCO₃, MgCO, MgCO₃, CaO, Ca₂CO₃, CaCO₃, SrCO, SrCO₃, BaCO, or BaCO₃. It should be noted that the layer containing alkali or alkaline earth compound can be further doped with an electron transport material, such as Alq₃, BeBq₂, TPBI, PBD, or TAZ.

The metal oxide layer can comprise oxide of transition metal, wherein the transition metal comprises atoms of Group IB, Group IIB, Group IVB, Group VB, Group VIIIB, Cr, or W. In some embodiments, the metal oxide layer can comprise WO, W₂O₃, WO₂, WO₃, W₂O₅, VO, V₂O₃, VO₂, or V₂O₅.

The semiconductor layer can comprise Si, Ge, GaAs, SiC, or SiGe. In an embodiment of the invention, the semiconductor layer is a non-doped semiconductor layer. Furthermore, the semiconductor layer comprises a n-type (B) doping ions (P, As, Sb) or p-type ions doping semiconductor layer.

A second electroluminescent unit 250 is formed on the connecting electrode structure 240, and the second electroluminescent unit 250 at least comprises a light emitting layer 231, and can further comprise a hole injection layer 232, a hole transport layer 233, an electron transport layer 234, and an electron injection layer 235. Finally, a cathode 260 is formed on the second electroluminescent unit 250. It should be noted that the plurality of electroluminescent units can exhibit the same emission color, resulting in a tandem organic electroluminescent diode 200 with red, blue, or green emission. Further, the plurality of electroluminescent units can exhibit different emission colors, thus, a tandem organic electroluminescent diode 200 with white emission can be achieved by mixing different colors.

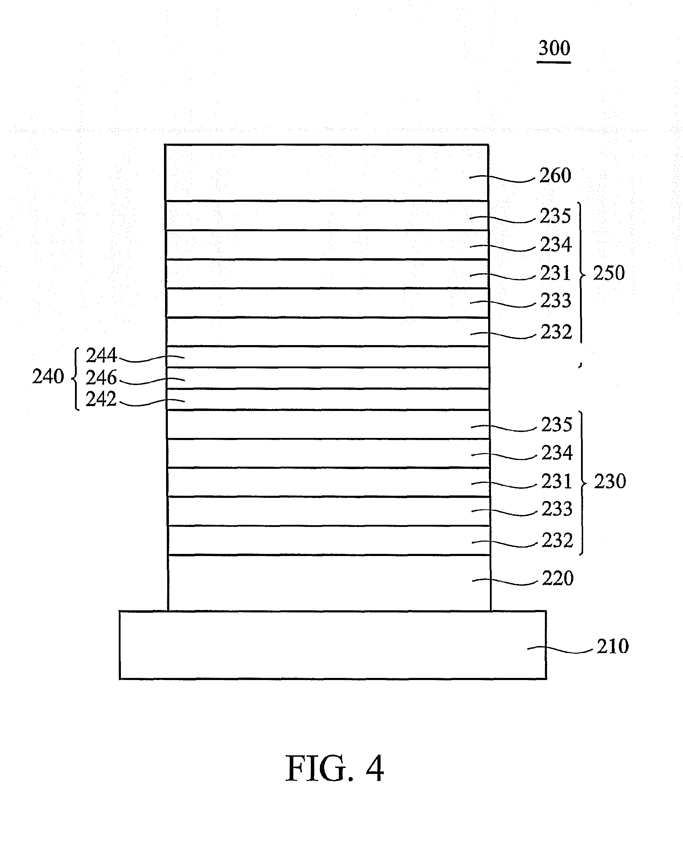

According to another embodiment of the invention, the connecting electrode structure 240 can further comprise a metal layer 246 formed between the layer containing an alkali or alkaline earth compound 242 and the metal oxide layer or semiconductor layer 244, referring to Fig. 4. Wherein, the metal layer 246 comprises Al, Ag, Au, or combinations thereof.

The following examples are intended to illustrate the invention more fully without limiting their scope, since numerous modifications and variations will be apparent to those skilled in this art.

### Single color organic electroluminescent device

### Comparative Example 1

A glass substrate with an indium tin oxide (ITO) film of 100 nm in thickness was provided and then washed by a cleaning agent, acetone, and isopropanol with ultrasonic agitation. After drying with nitrogen flow, the ITO film was subjected to uv/ozone treatment. Next, a hole injection layer, hole transport layer, light-emitting layer (with electron transport characteristic), electron injection layer, and aluminum electrode were subsequently formed on the ITO film at 10⁻⁵Pa, obtaining the electroluminescent device (1). For purposes of clarity, the materials and layers formed therefrom are described in the following.

The hole injection layer, with a thickness of 20nm, consisted of PEDT/PSS(Poly(3,4-ethylenedioxythiophene) poly(styrenesulfonate) aqueous dispersion). The hole transport layer, with a thickness of 40nm, consisted of NPB (N,N'-di-1-naphthyl-N,N'-diphenyl-1,1'-biphenyl-1,1'-biphenyl-4,4'-diamine). The light-emitting layer (with electron transport characteristic), with a thickness of 60nm, consisted of Alq₃ (tris (8-hydroxyquinoline) aluminum, yellowgreen emission (λₘₐₓ= 540 nm)). The electron injection layer, with a thickness of 1nm, consisted of Cs₂CO₃. The aluminum electrode had a thickness of 100nm.

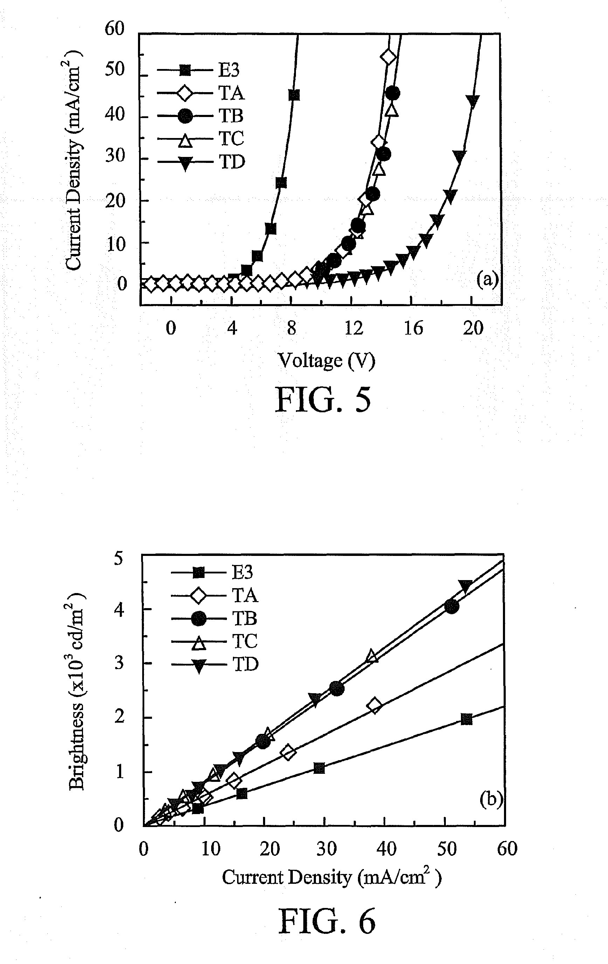

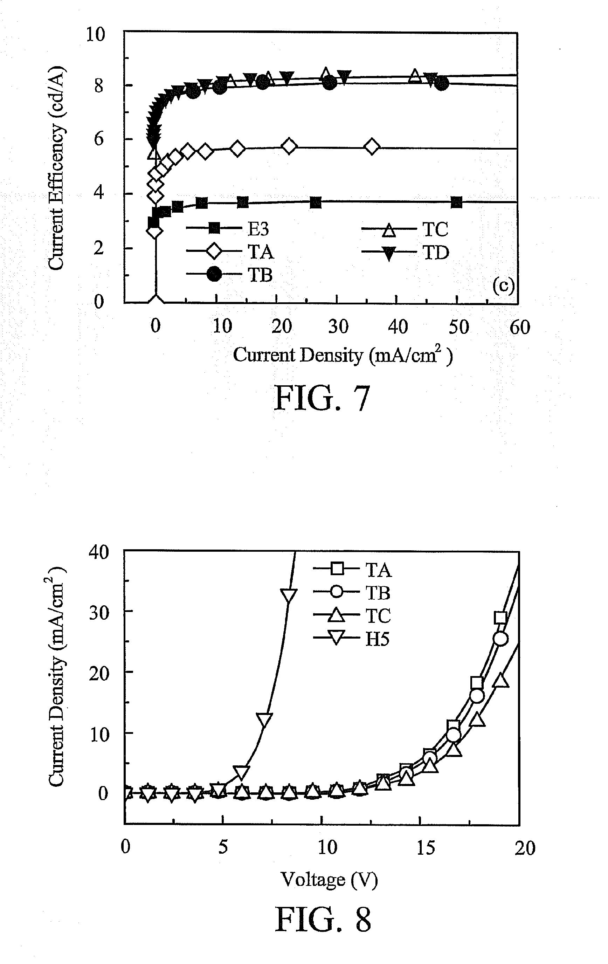

The optical property of electroluminescent device (1), as described in Comparative Example 1, was measured by PR650 (purchased from Photo Research Inc.) and Minolta LS 110. Fig. 5 illustrates a graph plotting operating voltage against current density of the electroluminescent device (1), Fig. 6 a graph plotting operating current density against brightness, and Fig. 7 a graph plotting operating current density against efficiency.

### Example 1

A glass substrate with an indium tin oxide (ITO) film of 100 nm was provided and then washed by a cleaning agent, acetone, and isopropanol with ultrasonic agitation. After drying with nitrogen flow, the ITO film was subjected to uv/ozone treatment. Next, a hole injection layer, first hole transport layer, first light-emitting layer (with electron transport characteristic), connecting electrode structure, second hole transport layer, second light-emitting layer (with electron transport characteristic), electron injection layer, and aluminum electrode were subsequently formed on the ITO film at 10⁻⁵Pa, obtaining the electroluminescent device (2). For purposes of clarity, the materials and layers formed therefrom are described in the following.

The hole injection layer, with a thickness of 20nm, consisted of PEDT/PSS (Poly(3,4-ethylenedioxythiophene) poly(styrenesulfonate) aqueous dispersion). The first hole transport layer, with a thickness of 40nm, consisted of NPB (N,N'-di-1-naphthyl-N,N'-diphenyl-1,1'-biphenyl-1,1'-biphenyl-4,4'-diamine). The first light-emitting layer (with electron transport characteristic), with a thickness of 40nm, consisted of Alq₃. The connecting electrode structure sequentially comprises the layer containing alkali or alkaline earth compounds, the metal layer and the metal oxide layer. The layer containing alkali or alkaline earth compounds, with a thickness of 20nm, consisted of Alq3 as host, and Cs₂CO₃ as dopant, wherein the weight ratio between Cs₂CO₃ and Alq₃ was 1:4. The metal layer, with a thickness of 5nm, consisted of Al. The metal oxide layer, with a thickness of 5nm, consisted of MoO₃. The second hole transport layer, with a thickness of 40nm, consisted of NPB (N,N'-di-1-naphthyl-N,N'-diphenyl-1,1'-biphenyl-1,1'-biphenyl-4,4'-diamine). The second light-emitting layer (with electron transport characteristic), with a thickness of 60nm, consisted of Alq₃. The electron injection layer, with a thickness of 1nm, consisted of Cs₂CO₃. The aluminum electrode has a thickness of 100nm.

The optical property of electroluminescent device (2), as described in Example 1, was measured by PR650 (purchased from Photo Research Inc.) and Minolta LS110. Fig. 5 illustrates a graph plotting operating voltage against current density of the electroluminescent device (2), Fig. 6 a graph plotting operating current density against brightness, and Fig. 7 a graph plotting operating current density against efficiency.

### Examples 2~4

Example 2 (electroluminescent device (3)) was performed the same as Example 1 except that the thickness of the metal layer was reduced to 1nm. Example 3 (electroluminescent device (4)) was performed the same as Example 2 except that Ag was substituted for Al, to serve as the material of the metal layer. Example 4 (electroluminescent device (5)) was performed the same as Example 1 except for the removal of the metal layer.

Figs. 5~7 also illustrate the differences between properties for the electroluminescent devices as described respectively in Comparative Example 1 and Examples 1~4. The measured results of optical properties for the (electroluminescent devices (1~5)) are shown as follows:

Brightness (measured at 20 mA/cm2): electroluminescent devices (2~4) (3000cd/m2) > electroluminescent device (5) (1200cd/m2) > electroluminescent device (1) (700cd/m2)

Efficiency (measured at 20mA/cm2): electroluminescent devices (2 and 4) (8.3cd/A)> electroluminescent device (3) (~8cd/A)> electroluminescent device (5) (5.8cd/A) >electroluminescent device (1) (3.8cd/A).

### White organic electroluminescent device

### Comparative Example 2

A glass substrate with an indium tin oxide (ITO) film of 100 nm was provided and then washed by a cleaning agent, acetone, and isopropanol with ultrasonic agitation. After drying with nitrogen flow, the ITO film was subjected to uv/ozone treatment. Next, a hole injection layer, hole transport layer, blue light-emitting layer, red light-emitting layer, electron transport layer, electron injection layer, and aluminum electrode were subsequently formed on the ITO film at 10⁻⁵Pa, obtaining the electroluminescent device (6). For purposes of clarity, the materials and layers formed therefrom are described in the following.

The hole injection layer, with a thickness of 60nm, consisted of HI-406 (derivatives of triphenylamine, manufactured and sold by Idemitsu Co., Ltd.). The hole transport layer, with a thickness of 20nm, consisted of HT-302 (derivatives of triphenylamine, manufactured and sold by Idemitsu Co., Ltd.). The blue light-emitting layer, with a thickness of 10nm, consisted of BD-04(derivatives of anthence, manufactured and sold by Idemitsu Co., Ltd.) as dopant, and BH-01 (derivatives of anthence, manufactured and sold by Idemitsu Co., Ltd.) as light-emitting material host, wherein the weight ratio between BD-04 and BH-01 was 2.5:97.5. The red light-emitting layer, with a thickness of 25nm, consisted of RD-01 (derivatives of anthence, manufactured and sold by Idemitsu Co., Ltd.) as dopant, and BH-01 as light-emitting material host, wherein the weight ratio between RD-01 and BH-01 was 2.68:97.32. The electron transport layer, with a thickness of 10nm, consisted of Alq₃ (tris (8-hydroxyquinoline) aluminum). The electron injection layer, with a thickness of 0.7nm, consisted of LiF). The aluminum electrode has a thickness of 100nm.

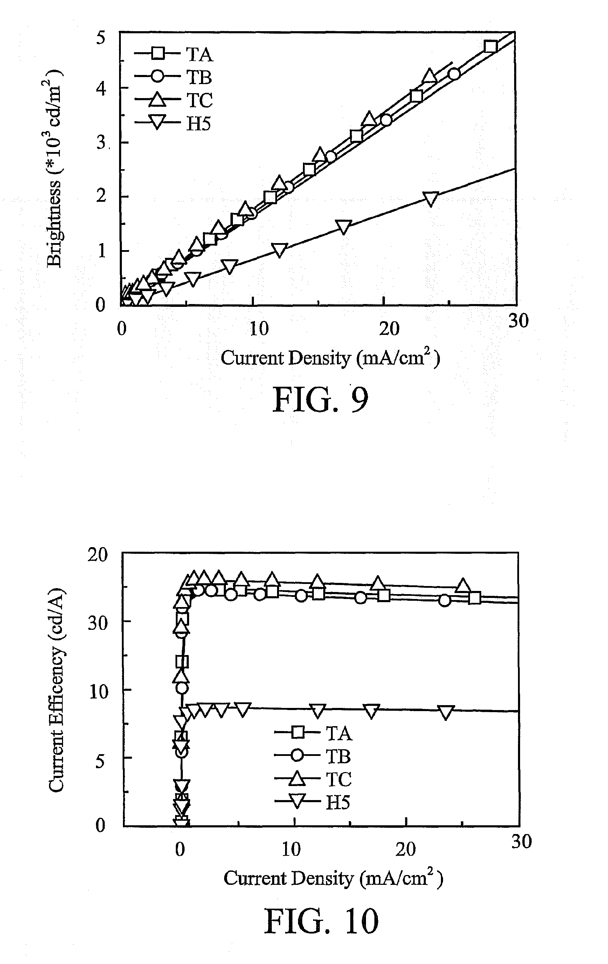

The optical property of electroluminescent device (6), as described in Comparative Example 2, was measured by PR650 (purchased from Photo Research Inc.) and Minolta LS110. Fig. 8 illustrates a graph plotting operating voltage against current density of the electroluminescent device (6), Fig. 9 a graph plotting operating current density against brightness, and Fig. 10 a graph plotting operating current density against efficiency.

### Example 5

A glass substrate with an indium tin oxide (ITO) film of 100 nm was provided and then washed by a cleaning agent, acetone, and isopropanol with ultrasonic agitation. After drying with nitrogen flow, the ITO film was subjected to uv/ozone treatment. Next, a first hole injection layer, first hole transport layer, first blue light-emitting layer, first red light-emitting layer, first electron transport layer, connecting electrode structure, second hole injection layer, second hole transport layer, second blue light-emitting layer, second red light-emitting layer, second electron transport layer, electron injection layer, and aluminum electrode were subsequently formed on the ITO film at 10⁻⁵Pa, obtaining the electroluminescent device (7). For purposes of clarity, the materials and layers formed therefrom are described in the following.

The first hole injection layer, with a thickness of 60nm, consisted of HI-406. The first hole transport layer, with a thickness of 20mn, consisted of H T - 3 0 2. The first blue light-emitting layer, with a thickness of 10nm, consisted of BD-04 as dopant, and BH-01 as light-emitting material host, wherein the weight ratio between BD-04 and BH-01 was 2.5:97.5. The first red light-emitting layer, with a thickness of 25nm, consisted of RD-01 as dopant, and BH-01 as light-emitting material host, wherein the weight ratio between RD-01 and BH-01 was 2.68:97.32. The first electron transport layer, with a thickness of 10nm, consisted of Alq₃. The connecting electrode structure sequentially comprises the layer containing alkali or alkaline earth compounds, the metal layer and the metal oxide layer. The layer containing alkali or alkaline earth compounds, with a thickness of 20nm, consisted of Alq₃ as host, and C_{S2}CO₃ as dopant, wherein the weight ratio between C_{S2}CO₃ and Alq₃ was 1:4 electron transport layer. The metal layer, with a thickness of 1nm, consisted of Al. The metal oxide layer, with a thickness of 5nm, consisted of MoO3. The second hole injection layer, with a thickness of 50nm, consisted of HI-406. The second hole transport layer, with a thickness of 20nm, consisted of HT-302. The second blue light-emitting layer, with a thickness of 10nm, consisted of BD-04 as dopant, and BH-01 as light-emitting material host, wherein the weight ratio between BD-04 and BH-O1 was 2.5:97.5. The second red light-emitting layer, with a thickness of 25nm, consisted of RD-01 as dopant, and BH-01 as light-emitting material host, wherein the weight ratio between RD-01 and BH-01 was 2.68:97.32. The second layer, with a thickness of 25nm, consisted of Alq₃. The electron injection layer, with a thickness of 1nm, consisted of Cs₂CO₃. The aluminum electrode has a thickness of 100nm.

The optical property of electroluminescent device (7), as described in Example 5, was measured by PR650 (purchased from Photo Research Inc.) and Minolta LS110. Fig. 8 illustrates a graph plotting operating voltage against current density of the electroluminescent device (7), Fig. 9 a graph plotting operating current density against brightness, and Fig. 10 a graph plotting operating current density against efficiency.

### Examples 6~7

Examples 6 and 7 (electroluminescent devices (8~9)) performed as Example 5 except that the thickness of the second hole injection layer were increased to 55nm and 60nm respectively.

Figs. 8~10 also illustrate the differences between properties for the electroluminescent devices as described respectively in Comparative Example 2 and Examples 5~7. The measured results of optical properties for the (electroluminescent devices (6-9)) are shown as follows:

Brightness (measured at 20 mA/cm2): electroluminescent devices (7~9) (3600cd/m2) > electroluminescent device (6) (1500cd/m2)

Efficiency (measured at 20mA/cm2): electroluminescent device (9) (17.5cd/A)> electroluminescent device (7) (16.9cd/A)> electroluminescent device (8) (16.6cd/A) >electroluminescent device (6) (8.3cd/A)

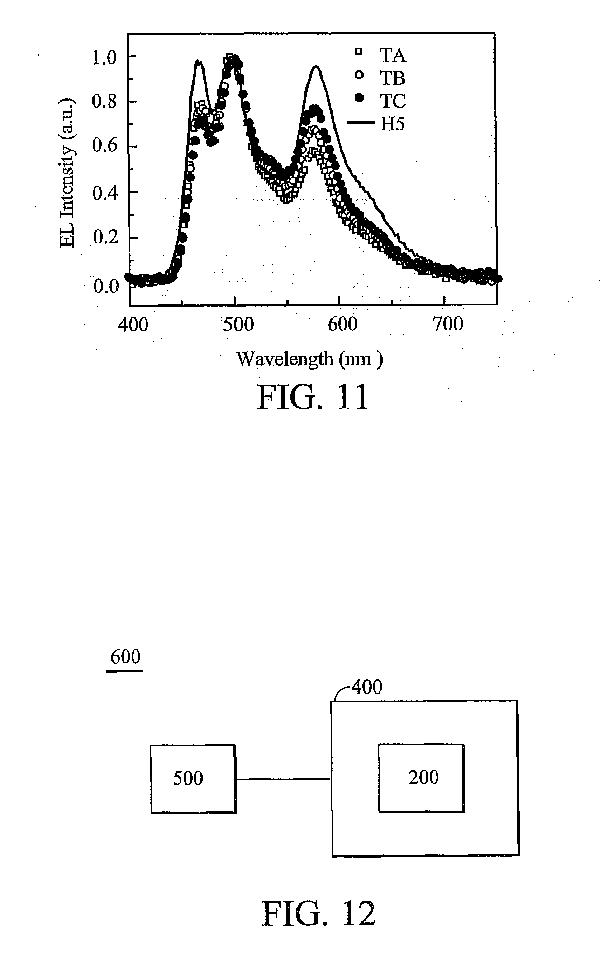

Further, referring to Fig. 11, the electroluminescent devices (7~9) have the same maximum emission wavelength (λmax) as the electroluminescent device (6), preventing the system for displaying images from color shift.

Fig. 12 schematically shows another embodiment of a system for displaying images which, in this case, is implemented as a display panel 400 or an electronic device 600. The described active matrix organic electroluminescent device can be incorporated into a display panel that can be an OLED panel. As shown in Fig. 12, the display panel 400 comprises an active matrix organic electroluminescent device, such as the normal organic electroluminescent diode 100 shown in Fig. 2 (or the tandem organic electroluminescent diode 200 or 300 shown in Fig. 3 or 4). The display panel 400 can form a portion of a variety of electronic devices (in this case, electronic device 600). Generally, the electronic device 600 can comprise the display panel 400 and an input unit 500. Further, the input unit 500 is operatively coupled to the display panel 400 and provides input signals (e.g., an image signal) to the display panel 400 to generate images. The electronic device 600 can be a mobile phone, digital camera, PDA (personal data assistant), notebook computer, desktop computer, television, car display, or portable DVD player, for example.

While the invention has been described by way of example and in terms of the preferred embodiments, it is to be understood that the invention is not limited to the disclosed embodiments. To the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A system for displaying images, comprising:
an organic electroluminescent diode having a composite electrode structure, wherein the composite electrode structure comprises:
a layer containing alkali or alkaline earth compounds, wherein the alkali or alkaline earth compound has carbonyl group or fluorine; and
a metal oxide layer or semiconductor layer, wherein the metal oxide layer comprises atoms of Group IB, Group IIB, Group IVB, Group VB, Group VIIIB, Cr , or W.

2. The system as claimed in claim 1, wherein the alkali or alkaline earth compound comprises a fluoride containing Li, Na, K, Rb, Cs, Be, Mg, Ca, Sr, or Ba.

3. The system as claimed in claim 2, wherein the alkali or alkaline earth compound comprises NaF, KF, RbF, CsF, BeF₂, MgF₂, CaF₂, SrF₂, or BaF₂

4. The system as claimed in claim 1, wherein the alkali or alkaline earth compound comprises a carbonyl compound containing Li, Na, K, Rb, Cs, Be, Mg, Ca, Sr, or Ba.

5. The system as claimed in claim 4, wherein the alkali or alkaline earth compound comprises Li₂CO₃, LiCO₃, Na₂CO₃, NaCO₃, K₂CO₃, KCO₃, Rb₂CO₃, RbCO₃, Cs₂CO₃, CsCO₃, BeCO, BeCO₃, MgCO, MgCO₃, CaO, Ca₂CO₃, CaCO₃, SrCO, SrCO₃, BaCO, or BaCO₃.

6. The system as claimed in any of the preceding claims, wherein the metal oxide layer comprises oxide of V (vanadium).

7. The system as claimed in claim 6, wherein the oxide of V comprises VO, V₂O₃, VO₂, or V₂O₅.

8. The system as claimed in any of claims 1 to 5, wherein the metal oxide layer comprises WO, W₂O₃, WO₂, WO₃, or W₂O₅.

9. The system as claimed in any of the preceding claims, wherein the semiconductor layer comprises Si, Ge, GaAs, SiC, or SiGe.

10. The system as claimed in any of the preceding claims, wherein the layer containing alkali or alkaline earth compound is doped with electron transport material.

11. The system as claimed in any of the preceding claims, wherein the composite electrode structure further comprises a metal layer formed between the layer containing alkali or alkaline earth compound and the metal oxide layer or semiconductor layer.

12. The system as claimed in claim 11, wherein the metal layer comprises Al, Ag, Au, or combinations thereof.

13. The system as claimed in any of the preceding claims, further comprising a display panel, wherein the display panel comprises the organic electroluminescent diode.

14. The system as claimed in claim 13, further comprising an electronic device, wherein the electronic device comprises:
the display panel; and
an input unit coupled to the organic electroluminescent diode.

15. The system as claimed in claim 14, wherein the electronic device is a mobile phone, digital camera, PDA (personal digital assistant), notebook computer, desktop computer, television, car display, or portable DVD player.
